# EUROPEAN PATENT APPLICATION

(11) **EP 4 657 411 A1**
(43) Date of publication of application: **03.12.2025**
(21) Application number: 24747398.6
(22) Date of filing: 12.01.2024
(51) Int. Cl.: G09F 9/30, G06F 1/16, H10K 59/80, H10K 59/60, H05K 5/03

(54) **ELECTRONIC DEVICE**

(30) Priority: 25.01.2023 KR 20230009715
(71) Applicant: Samsung Display Co., Ltd., Yongin-si, Gyeonggi-do 17113 (KR)
(72) Inventor: NAM, Yunoh, Yongin-Si Gyeonggi-do 17113 (KR); BAE, Kyuhan, Yongin-Si Gyeonggi-do 17113 (KR); BAE, Joohyang, Yongin-Si Gyeonggi-do 17113 (KR); LEE, Seunghyeon, Yongin-Si Gyeonggi-do 17113 (KR)
(74) Representative: Dr. Weitzel & Partner
(86) International application number: PCT/KR2024/000601
(87) International publication number: WO 2024/158160

(57) **Abstract**

Provided is an electronic device including a display panel which displays an image, a cover panel contacting a lower part of the display panel, having an opening defined therein, and having a gray color reflectance, and an electronic module disposed overlapping the opening on a plane, and the cover panel includes a first cover layer not overlapping the opening and having a first reflectance, and a second cover layer not overlapping the opening and disposed under the first cove layer, and having a second reflectance.

## Description

### TECHNICAL FIELD

The present disclosure herein relates to an electronic device, and more particularly, to an electronic device with improved display characteristics.

### BACKGROUND ART

An electronic device provides various functions capable of communicating closely with a user, for example, displaying an image to provide information to a user or detecting a user's input.

An electronic device may include an electronic module that receives external signals, or provides output signals to the outside. In recent electronic devices, the electronic module may be disposed on and assembled to a rear surface of a display panel.

### DISCLOSURE OF THE INVENTION

### TECHNICAL PROBLEM

The present disclosure may provide an electronic device with improved display characteristics.

The present disclosure may also provide an electronic device capable of reducing the difference in luminance between an opening of a cover panel and a region adjacent thereto.

The present disclosure may also provide an electronic device capable of reducing the difference in luminance between an opening of a cover panel and a region adjacent thereto by decreasing or increasing the reflectance of the region adjacent to the opening.

### TECHNICAL SOLUTION

An embodiment of the inventive concept provides an electronic device including a display panel configured to display an image a cover panel contacting a lower part of the display panel, having an opening defined therein, and having a gray color reflectance, and an electronic module disposed overlapping the opening on a plane, wherein the cover panel includes a first cover layer not overlapping the opening, and having a first reflectance, a second cover layer not overlapping the opening, disposed under the first cover layer, and having a second reflectance.

In an embodiment, the second reflectance may be equal to or less than the first reflectance.

In an embodiment, the cover panel may have a reflectance equal to or greater than that of the display panel.

In an embodiment, one of the first cover layer and the second cover layer may have a gray color, and the other of the first cover layer and the second cover layer may have a white color.

In an embodiment, the first cover layer may have a gray color or a white color, and the second cover layer may have a gray color or a black color.

In an embodiment, the cover panel may further include a protective film disposed between the first cover layer and the second cover layer.

In an embodiment, the protective film may be a transparent layer.

In an embodiment, the protective film may have a reflectance equal to or greater than the second reflectance.

In an embodiment, the cover panel may include a lower member disposed under the second cover layer, the first cover layer may have adhesiveness, and may be in contact with each of the protective film and the display panel, and the second cover layer may have adhesiveness, and may be in contact with each of the protective film and the lower member.

In an embodiment, the first cover layer may have adhesiveness, and may be in contact with each of the protective film and the display panel, and the second cover layer may be a cushion layer.

In an embodiment, the first cover layer may be in contact with one side of the protective film, and the second cover layer may be in contact with the other side of the protective film.

In an embodiment, the first cover layer may include a plurality of patterns and bond the protective film and the display panel to each other.

In an embodiment of the inventive concept, an electronic device includes a display panel configured to display an image, a cover panel contacting a lower part of the display panel, and having an opening defined therein, and an electronic module disposed overlapping the opening on a plane, the cover panel includes a protective film not overlapping the opening, a first cover layer disposed between the display panel and the protective film, and in contact with the protective film, and a second cover layer disposed under the protective film, and in contact with the protective film, and the cover panel has a reflectance which is a color reflectance of about 15% to about 70%.

In an embodiment, the first cover layer may have a gray color or a white color, and the second cover layer may have a gray color or a black color.

In an embodiment, the cover panel may include a lower member disposed under the second cover layer, a first adhesive layer which has adhesiveness, and is in contact with each of the display panel and the first cover layer, and a second adhesive layer which has adhesiveness, and is in contact with each of the second cover layer and the lower member.

In an embodiment, one among the first adhesive layer, the first cover layer, the protective film, the second cover layer, and the second adhesive layer may have a white color or a gray color, and the others among the first adhesive layer, the first cover layer, the protective film, the second cover layer, and the second adhesive layer may be transparent layers.

In an embodiment, the first adhesive layer may have a white color or a gray color, and the second adhesive layer may have a white color or a gray color.

In an embodiment, the protective film, the first cover layer, the second cover layer, the first adhesive layer, and the second adhesive layer may be transparent, and the lower member may have a reflectance substantially equal to a gray color reflectance.

In an embodiment of the inventive concept, an electronic device includes a display panel configured to display an image, a cover panel contacting a lower part of the display panel, having an opening defined therein, and having a gray color reflectance, and an electronic module disposed overlapping the opening on a plane, and the cover panel includes a protective film not overlapping the opening, a first cover layer disposed between the display panel and the protective film, and in contact with the protective film, a first adhesive layer disposed between the first cover layer and the display panel, and in contact with each of the first cover layer and the display panel, a lower member disposed under the protective film, a second cover layer disposed between the lower member and the protective film, and in contact with the protective film, and a second adhesive layer disposed between the second cover layer and the lower member, and in contact with each of the second cover layer and the lower member.

In an embodiment, the protective film may be a transparent layer, the first cover layer may have a gray color or a white color, and the second cover layer may have a gray color or a black color.

### ADVANTAGEOUS EFFECTS

An electronic device according to an embodiment of the inventive concept may have improved display characteristics.

In an electronic device according to an embodiment of the inventive concept, the luminance difference between an opening of a cover panel and a region adjacent thereto may be reduced.

In an electronic device according to an embodiment of the inventive concept, the luminance difference between an opening of a cover panel and a region adjacent thereto may be reduced by decreasing or increasing the reflectance of the region adjacent to the opening of the cover panel.

### BRIEF DESCRIPTION OF THE DRAWINGS

FIG. 1 is a perspective view of an electronic device according to an embodiment of the inventive concept;
FIG. 2 is a perspective view illustrating a folded state of an electronic device according to an embodiment of the inventive concept;
FIG. 3 is a perspective view of an electronic device according to an embodiment of the inventive concept;
FIG. 4 is a perspective view illustrating a folded state of an electronic device according to an embodiment of the inventive concept;
FIG. 5 is an exploded perspective view of an electronic device according to an embodiment of the inventive concept;
FIG. 6 is a cross-sectional view of an electronic device according to an embodiment of the inventive concept;
FIG. 7 is a cross-sectional view illustrating a portion of an electronic device according to an embodiment of the inventive concept;
FIGS. 8A through 8D are cross-sectional views each illustrating a portion of an electronic device according to an embodiment of the inventive concept;
FIGS. 9A through 9C are cross-sectional views each illustrating a portion of an electronic device according to an embodiment of the inventive concept;
FIG. 10 is a cross-sectional view illustrating a portion of an electronic device according to an embodiment of the inventive concept;
FIG. 11 is a cross-sectional view illustrating a portion of an electronic device according to an embodiment of the inventive concept; and
FIGS. 12A through 12F are photos showing luminance differences in a display region.

### MODE FOR CARRYING OUT THE INVENTION

In this specification, it will be understood that when an element (or a region, a layer, a portion, or the like) is referred to as being "on", "connected to" or "coupled to" another element, it may be directly disposed on, connected or coupled to the other element, or intervening elements may be disposed therebetween.

Like reference numerals or symbols refer to like elements throughout. In the drawings, the thickness, the ratio, and the size of the element are exaggerated for effective description of the technical contents. As used herein, the term "and/or" includes any and all combinations of one or more of the associated listed items.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the scope of the inventive concept. Similarly, a second element, component, region, layer or section may be termed a first element, component, region, layer or section. As used herein, the singular forms, "a", "an" and "the" are intended to include the plural forms as well, unless the context clearly indicates otherwise.

Also, terms of "below", "on lower side", "above", "on upper side", or the like may be used to describe the relationships of the elements illustrated in the drawings. These terms have relative concepts and are described on the basis of the directions indicated in the drawings.

It will be further understood that the terms "includes" and/or "have", when used in this specification, specify the presence of stated features, integers, steps, operations, elements, components, and/or groups thereof, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the inventive concept will be described with reference to the accompanying drawings.

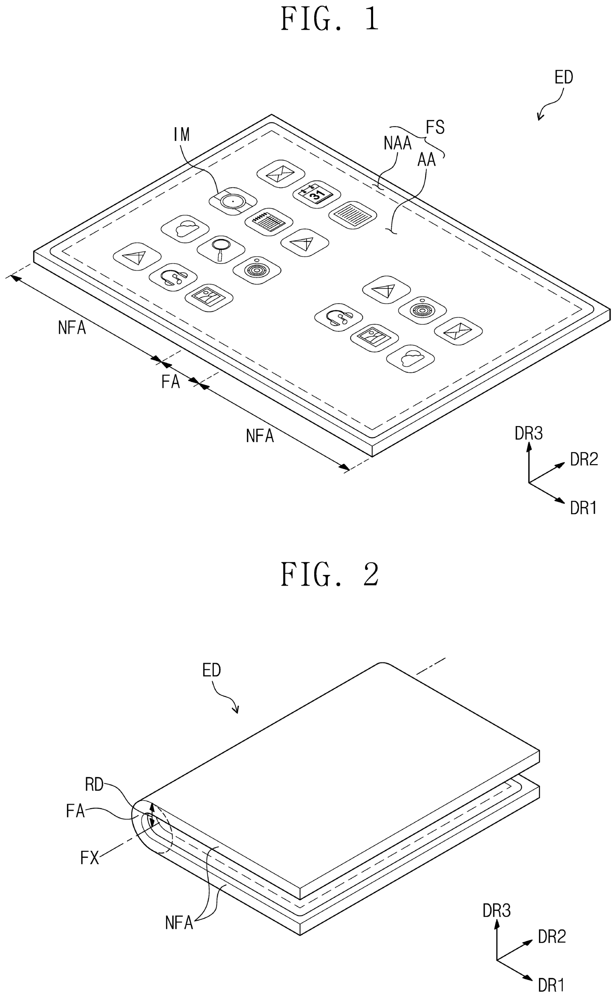

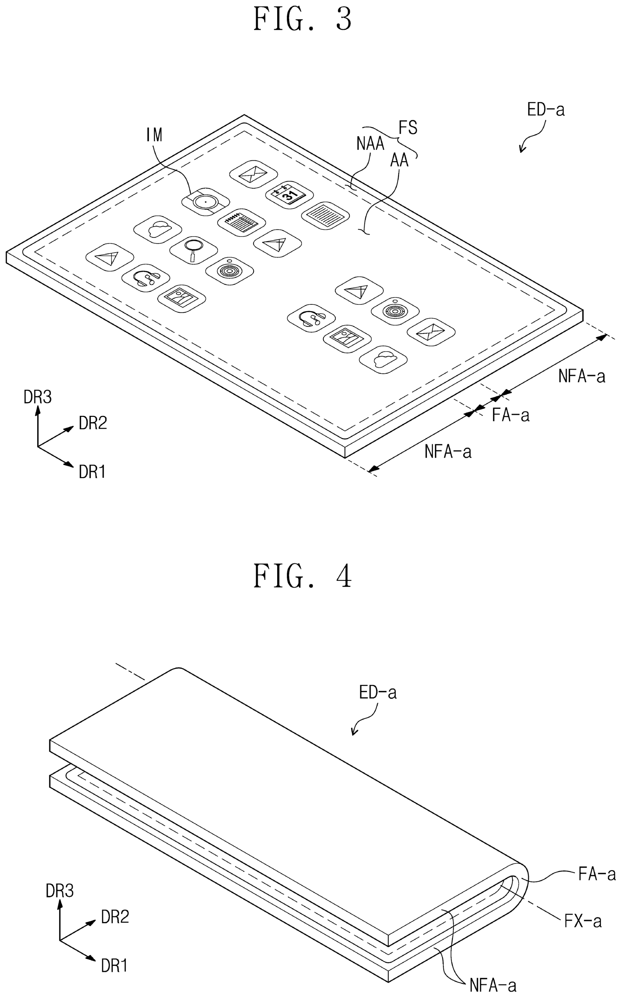

FIG. 1 is a perspective view of an electronic device according to an embodiment of the inventive concept, and FIG. 2 is a perspective view illustrating a folded state of the electronic device illustrated in FIG. 1. FIG. 3 is a perspective view of an electronic device according to an embodiment of the inventive concept, and FIG. 4 is a perspective view of the electronic device illustrated in FIG. 3.

The electronic device ED or ED-a according to an embodiment may be a smartphone, a personal computer, a laptop computer, a personal digital assistance, a car navigation system, a game console, a smart television, etc. FIGS. 1 through 4, etc., exemplarily illustrate a smartphone as the electronic device ED or ED-a according to an embodiment.

The electronic device ED or ED-a according to an embodiment may have a rectangular shape having long sides extending in a first directional axis DR1, and short sides extending in a second directional axis DR2 crossing the first directional axis DR1. However, an embodiment of the inventive concept is not limited thereto, and the electronic device ED or ED-a may have various shapes such as a circular or polygonal shape on a plane. The electronic device ED or ED-a may be a flexible electronic device.

In the electronic device ED or ED-a according to an embodiment, a display surface FS in which an image IM is displayed may be parallel to a plane defined by the first directional axis DR1 and the second directional axis DR2. The normal direction of the display surface FS that is the thickness direction of the electronic device ED or ED-a is indicated by a third directional axis DR3. The display surface FS may correspond to a front surface of the electronic device ED or ED-a. A front surface (or upper surface) and a rear surface (or lower surface) of each of members are distinguished on the basis of the third directional axis DR3. However, directions indicated by the first through third directional axes DR1, DR2, and DR3 are relative concepts, and may be changed to other directions. Hereinafter, first through third directions are the respective directions indicated by the first through third directional axes DR1, DR2, and DR3, and denoted as the same reference numerals or symbols.

The electronic device ED or ED-a according to an embodiment may include at least one folding region FA or FA-a. The electronic device ED or ED-a according to an embodiment may include at least one folding region FA or FA-a and non-folding regions NFA or NFA-a adjacent to the folding region FA or FA-a. The electronic device ED or ED-a may include the folding region FA or FA-a and a plurality of non-folding regions NFA or NFA-a. The folding region FA or FA-a may be disposed between the non-folding regions NFA or NFA-a.

In the electronic device ED according to the embodiment illustrated in FIGS. 1 and 2, the folding region FA and the non-folding regions NFA may be arranged to be adjacent to each other in the first directional axis DR1. The folding region FA may be a portion deformable into a folded state with respect to a folding axis FX extending in one direction that is the second directional axis DR2. In an embodiment, the folding axis FX may extend in a direction parallel to a short side of the electronic device ED. In an embodiment, the folding region FA may have a radius of curvature RD of about 5 mm or less.

Except for the folding operation, the electronic device ED-a illustrated in FIG. 3 may have substantially the same configuration as the electronic device ED illustrated in FIG. 1. According to the embodiment illustrated in FIGS. 3 and 4, the electronic device ED-a may be folded such that the folding region FA-a is bent with respect to a folding axis FX-a parallel to the first directional axis DR1. The folding axis FX-a may be defined as a long axis parallel to a long side of the electronic device ED-a. That is, the electronic device ED illustrated in FIG. 1 may be folded with respect to a short axis, and unlike the electronic device ED, the electronic device ED-a illustrated in FIG. 3 may be folded with respect to a long axis.

FIGS. 1 through 4 exemplarily illustrate one folding region FA or FA-a and two non-folding regions NFA or NFA-a, but the numbers of folding region FA or FA-a and the non-folding regions NFA or NFA-a are not limited thereto. For example, the electronic device ED or ED-a may include at least three non-folding regions NFA or NFA-a, and a plurality of folding regions FA or FA-a disposed between the non-folding regions NFA or NFA-a.

In the electronic device ED or ED-a according to an embodiment, the non-folding regions NFA or NFA-a may be disposed symmetrically with each other with respect to the folding region FA or FA-a. However, an embodiment of the inventive concept is not limited thereto, and the folding region FA or FA-a may be disposed between the non-folding regions NFA or NFA-a, but the areas of two non-folding regions NFA or NFA-a, facing each other with respect to the folding region FA or FA-a, may differ from each other.

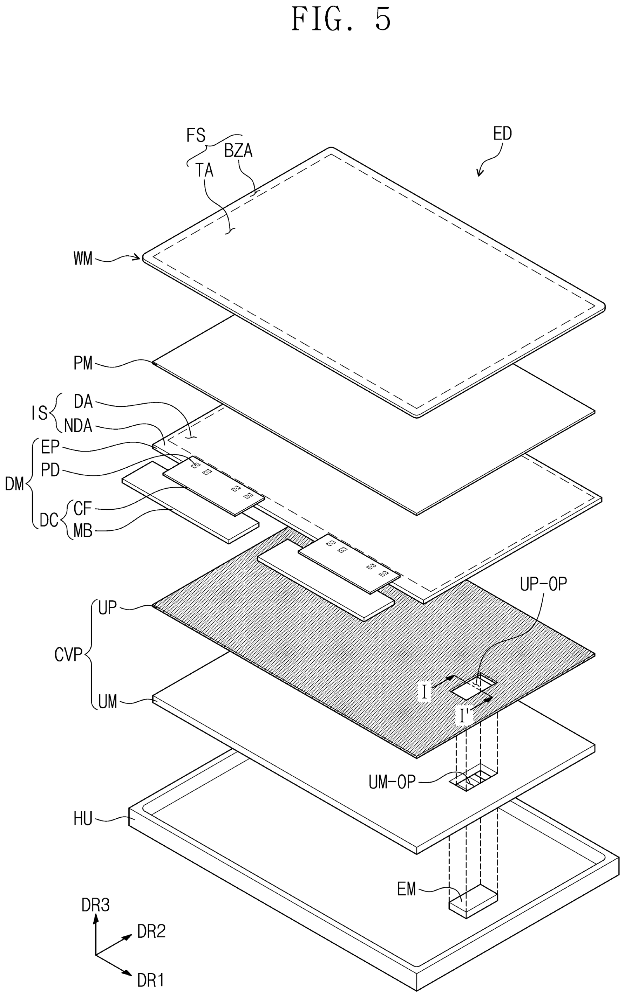

Referring to FIGS. 1 through 4, when the electronic device ED or ED-a according to an embodiment is folded, the electronic device ED or ED-a may be in-folded such that the non-folding regions NFA or NFA-a may face each other, and the display surface FS is not exposed to the outside. However, an embodiment of the inventive concept is not limited thereto, and the electronic device ED or ED-a, unlike what is illustrated in the drawing, may be out-folded such that the display surface FS is exposed to the outside. In addition, unlike what is illustrated in the drawing, the electronic device according to an embodiment may further include a back display surface (not shown). The back display surface (not shown) may be an external display surface to be exposed to the outside when the electronic device is in-folded and thus the display surface FS of the front surface is not exposed to the outside. The back display surface (not shown) may provide a display surface through a back window disposed on a housing HU (see FIG. 5) side. In case of including the back display surface (not shown), the electronic device ED or ED-a may further include a display module in addition to a display module DM (see FIG. 5) which displays the image IM on the display surface FS of the front surface.

FIGS. 1 through 4 illustrate a foldable electronic device, but an embodiment of the inventive concept is not limited thereto. In an embodiment, the electronic device may be a rollable electronic device, a bendable electronic device including a bending part, a flat rigid electronic device, a curved rigid electronic device, or the like.

The display surface FS of the electronic device ED or ED-a may include an active region AA and a peripheral region NAA. The active region AA may be activated in response to electrical signals. The active region AA is a region in which the image is displayed, and which may detect various types of external inputs. The external input may include various types of inputs provided from the outside. For example, the external input may include a contact by a part of a user's body such as a user's hand, and also an external input applied while approaching or being adjacent to the electronic device ED or ED-a at a predetermined distance (for example, a hovering). In addition, the external input may include various types such as power, pressure, or light, and is not limited to any one embodiment.

The peripheral region NAA may substantially define the shape of the active region AA. The peripheral region NAA is adjacent to the active region AA. The peripheral region NAA may surround the active region AA. Accordingly, this is exemplarily illustrated, but the peripheral region NAA may also be disposed adjacent only to one side of the active region AA, or may be omitted.

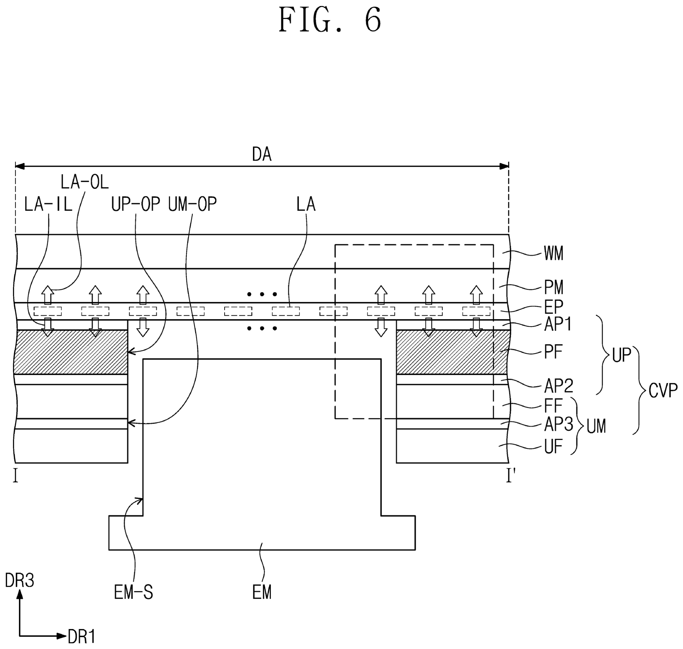

FIG. 5 is an exploded perspective view of the electronic device according to the embodiment of the inventive concept illustrated in FIG. 1. FIG. 6 is a cross-sectional view, taken along line I-I' of FIG. 5, of an electronic device according to an embodiment of the inventive concept.

Referring to FIGS. 5 and 6, the electronic device ED according to an embodiment of the inventive concept may include an electronic module EM, a display panel EP, and a window WM. The window WM may be disposed on the display panel EP.

The electronic device ED may further include a housing HU that accommodates the electronic module EM and a display module DM. In addition, the electronic device ED may include a polarization member PM disposed above the display panel EP, and a cover panel CVP disposed under the display panel EP.

In the electronic device ED according to an embodiment, which is foldable along at least one folding axis extending in one direction, in order to minimize damage due to repetition of folding and unfolding operations, the entire thickness of members disposed under the display panel EP may be controlled so as to correspond to the entire thickness of members disposed above the display panel EP. That is, additional members may be disposed under the display panel EP, so that a neutral surface is positioned in the display panel EP.

In the electronic device ED according to an embodiment, the window WM is disposed on the display module DM and covers a front surface IS of the display panel EP. The window WM includes an upper surface FS that is exposed to the outside. The display surface FS (see FIG. 1) of the electronic device ED may be defined substantially by the upper surface FS of the window WM. A transmission region TA in the upper surface FS of the window WM may be an optically transparent region. The transmission region TA may have a shape corresponding to a display region DA of the display panel DP. For example, the transmission region TA overlaps the entire surface or at least a portion of the display region DA. The image IM (see FIG. 1) displayed in the display region DA of the display panel EP may be viewed from the outside through the transmission region TA.

In the upper surface FS of the window WM, a bezel region BZA may be a region having a relatively lower light transmittance than the transmission region TA. The shape of the transmission region TA may be defined by the bezel region BZA. The bezel region BZA may be adjacent to the transmission region TA, and may surround the transmission region TA.

The bezel region BZA may have a predetermined color. When the window WM is provided as a glass or polymer substrate, the bezel region BZA may be a colored layer printed or deposited on one surface of the glass or polymer substrate. In addition, the bezel region BZA may also be formed by coloring a partial region of the glass or polymer substrate.

The bezel region BZA may cover the non-display region NDA of the display panel EP to block the non-display region NDA from being viewed from the outside. Meanwhile, this is exemplarily illustrated, and the bezel region BZA may also be omitted from the window WM according to an embodiment of the inventive concept.

The display module DM may be disposed under the window WM. The display module DM may include the display panel EP and a circuit board DC.

According to an embodiment of the inventive concept, the display panel EP may serve as an output device. For example, the display panel EP may display an image in the active region AA (see FIG. 1), and a user may acquire information through the image. In addition, the display panel EP may serve as an input device for detecting an external input applied to the active region AA (see FIG. 1).

The display panel EP includes a front surface IS and a rear surface opposed to the front surface IS. The front surface IS may include a display region DA that displays an image and detects an external input, and a non-display region NDA adjacent to the display region. In the non-display region NDA, a driving circuit for driving pixels of the display region DA and wires connected thereto may be disposed, and wires connected to sensing electrodes for detecting an external input may be disposed. The display region DA may overlap at least a portion of the active region AA (see FIG. 1), and the non-display region NDA may overlap at least a portion of the peripheral region NAA (see FIG. 1).

The cover panel CVP may include a lower panel UP and a lower member UM. The cover panel CVP may have a gray color, and may be semitransparent. As illustrated in the drawing, the lower panel UP may have a gray color, and the lower member UM may not have a gray color, but an embodiment of the inventive concept is not limited to what is illustrated in the drawing, and both of the lower panel UP and the lower member UM may have gray colors, or only the lower member UM may have a gray color.

An opening may be defined in the cover panel CVP. The opening of the cover panel CVP may include an opening UP-OP of the lower panel UP, and an opening UM-OP of the lower member UM.

The opening defined in the cover panel CVP may have a polygonal shape on a plane, as illustrated in the drawing. However, an embodiment of the inventive concept is not limited to what is illustrated in the drawing, and the opening may have a circular or oval shape on a plane defined by a first directional axis DR1 and a second directional axis DR2. For example, the opening defined in the cover panel CVP may have a shape corresponding to the electronic module EM.

The opening of the cover panel CVP may be positioned in the display region DA. That is, each of the opening UP-OP of the lower panel UP and the opening UM-OP of the lower member UM may be positioned in the display region. The opening of the cover panel CVP may be a portion which is spaced apart from the non-display region NDA and defined in the display region DA.

That is, the opening of the cover panel CVP may overlap the active region AA (see FIG. 1), and may be spaced apart from the peripheral region NAA (see FIG. 1) on a plane.

The circuit board DC may be connected to the display panel EP. The circuit board DC may include a flexible board CF and a main board MB. The flexible board CF may include an insulation film and conductive lines mounted on the insulation film. The conductive lines are connected to pads PD, and electrically connects the circuit board DC to the display panel EP.

According to an embodiment of the inventive concept, the flexible board CF may be assembled in a curved state. Accordingly, the main board MB may be disposed under the display panel EP, and may thus be stably accommodated in a space provided by the housing HU. Meanwhile, in an embodiment, the flexible board CF may also be omitted, and at this time, the main board MB may be directly connected to the display panel EP.

The main board MB may include signal lines and electronic elements that are not shown in the drawing. The electronic elements may be connected to the signal lines, and may thus be electrically connected to the display panel EP. The electronic elements generate various electrical signals such as signals for generating the image IM or signals for detecting an external input, or process the detected signals. Meanwhile, the main board MB may be provided in plurality corresponding to each of the signals for generating or processing, but is not limited to any one embodiment.

The polarization member PM may be disposed on the display panel EP. The polarization member PM may include a polarizer, and serve to reduce reflection of external light.

The lower member UM disposed under the display panel EP may be further provided. The lower member UM may serve as a protective member for protecting the display module DM from external impact. In addition, the lower member UM may be provided to have a predetermined thickness or more, and may thus serve to compensate a step difference of the electronic device ED. That is, controlling the thickness of the lower member UM may make the neutral surface positioned in the display panel EP, thereby improving the durability of the electronic device that performs a folding or unfolding operation.

The electronic module EM is disposed under the display panel EP. The electronic module EM may overlap the opening of the cover panel CVP. The electronic module EM may receive an external input transferred through the opening of the cover panel CVP, or provide an output through the opening of the cover panel CVP. In an embodiment, the electronic module EM may be a fingerprint sensor, but an embodiment of the inventive concept is not limited thereto. The electronic module EM may be a proximity sensor, an illuminance sensor, or a camera module, and is not limited to any one embodiment. In addition, the opening of the cover panel CVP may be provided in plurality, and the electronic module EM may also be provided in plurality corresponding to the plurality of openings of the cover panel CVP.

The electronic module EM may be accommodated in the housing HU. In the electronic device ED according to an embodiment, the electronic module EM may be disposed overlapping the opening UP-OP of the lower panel UP and the opening UM-OP of the lower member UM defined by passing through the components disposed on the electronic module EM. The electronic module EM may receive an input transferred from the outside through an opening region of the window WM overlapping the openings UP-OP and UM-OP formed by passing through each of the components, or may provide an output to a user through the opening region of the window WM. In addition, the opening region of the window WM according to an embodiment may be variously changed in the active region AA (see FIG. 1) according to a region in which the electronic module EM is disposed. Moreover, the positions of the openings UP-OP and UM-OP, defined by passing through the components disposed on the electronic module EM, may also be variously changed according to a region in which the electronic module EM is disposed.

In the electronic device ED according to an embodiment of the inventive concept, since the electronic module EM is disposed overlapping the active region AA (see FIG. 1), an additional space for disposing the electronic module EM in the peripheral region NAA (see FIG. 1) may be omitted. Accordingly, in the electronic device ED according to an embodiment of the inventive concept, dead spaces may be reduced by minimizing the peripheral region NAA (see FIG. 1).

In the electronic device ED or ED-a (see FIG. 3) according to an embodiment of the inventive concept, the housing HU may provide a predetermined accommodation space. The display module DM and the electronic module EM may be accommodated in the accommodation space, and protected from external impact. The housing HU may include a material with relatively high rigidity. For example, the housing HU may include a plurality of frames and/or plates composed of glass, a polymer material, or a metal material. In addition, although not illustrated in the drawing, a control part, a hinge, and the like for controlling a folding or bending operation of the electronic device ED may be included in the housing HU.

The window WM or the polarization member PM may make the electronic module invisible from the outside. Also, the window WM or the polarization member PM may make the cover panel CVP invisible from the outside, and is not limited to any one embodiment.

Referring to FIG. 6, the display panel EP according to an embodiment of the inventive concept may include a light source LA. The light source LA may be disposed in the display region DA, and may correspond to the aforementioned pixels of the display region DA. The light source LA may emit light LA-OL above the display panel EP, and toward the window WM. In addition, the light source LA may emit light LA-IL toward the cover panel CVP disposed under the display panel EP.

For the convenience of description, the light LA-OL emitted toward the window WM is described as first light LA-OL, and the light LA-IL emitted toward the cover panel CVP is described as second light LA-IL.

For the convenience, only the first light LA-OL and the second light LA-IL emitted in a third directional axis DR3 are illustrated in the drawing, but an embodiment of the inventive concept is not limited thereto, and light may be emitted in a direction different from the third directional axis DR3.

The first light LA-OL may be directly emitted to the outside of the electronic device ED, but the second light LA-IL may be emitted to the outside of the electronic device ED after reflected on the display panel EP or the cover panel CVP.

The reflectance of the display panel EP may be different from the reflectance of the cover panel CVP. When the second light LA-IL is emitted to the outside of the electronic device ED after reflected on the display panel EP or the cover panel CVP, the amount of light reflected on the display panel EP may be different from the amount of light reflected on the cover panel CVP due to the difference in reflectance between the display panel EP and the cover panel CVP. Accordingly, in the display region DA, a staining phenomenon may occur due to the luminance difference. The occurrence of staining results in deterioration of display quality.

According to an embodiment of the inventive concept, an opening may be defined in the cover panel CVP. The opening of the cover panel CVP, as previously described, may include the opening UP-OP of the lower panel UP and the opening UM-OP of the lower member UM. The second light LA-IL emitted from the light source LA of the display panel EP is reflected on the cover panel CVP at a portion where the cover panel CVP and the display panel EP come into contact, but the second light LA-IL is not reflected on the cover panel CVP at a portion where the display panel EP overlaps the opening UP-OP. Therefore, a portion of the display region DA overlapping the openings UP-OP and UM-OP and a portion of the display region DA not overlapping the openings UP-OP and UM-OP differ in luminance from each other.

The reflectance of a portion where the display panel EP overlaps the openings UP-OP and UM-OP may be substantially the same as the reflectance of the display panel EP. The reflectance of the display panel EP at a portion of the display region DA overlapping the openings UP-OP and UM-OP and the reflectance of the display panel EP at a portion of the display region DA not overlapping the openings UP-OP and UM-OP may each be controlled, so that it may be possible to reduce the luminance difference between the portion of the display region DA overlapping the openings UP-OP and UM-OP and the portion of the display region DA not overlapping the openings UP-OP and UM-OP.

According to an embodiment of the inventive concept, the difference in reflectance between the display panel EP and the cover panel CVP may be designed to have a predetermined value, thereby reducing the difference in luminance. For example, the predetermined value may be about 0, but is not fixed thereto, and may be changed according to the product design.

According to an embodiment of the inventive concept, the reflectance of the cover panel CVP may be controlled. For example, the reflectance of the cover panel CVP may be equal to or greater than the reflectance of the display panel EP. However, an embodiment of the inventive concept is not limited thereto, and the reflectance of the display panel EP, as well as the reflectance of the cover panel CVP, may be controlled, and is not limited to any one embodiment.

According to an embodiment of the inventive concept, the cover panel CVP may have substantially the same color as the gray color. Having the same color as the gray color means that the color reflectance is same as the reflectance of the gray color. That is, the cover panel CVP may have a gray color reflectance.

The gray color reflectance is greater than the black color reflectance and less than the white color reflectance. That is, the gray color reflectance may be greater than about 15% and less than about 70%. Desirably, the color reflectance may be about 20% to about 68%.

According to an embodiment of the inventive concept, each of entire components constituting the cover panel CVP may have a gray color reflectance. However, an embodiment of the inventive concept is not limited thereto, and the cover panel CVP as a whole may have a gray color reflectance in consideration of the reflectance of each of the entire components constituting the cover panel CVP. For example, a partial configuration of the cover panel CVP may have a black color, and another partial configuration of the cover panel CVP may have a white or gray color. Alternatively, a partial configuration of the cover panel CVP may have a gray color, and another partial configuration of the cover panel CVP may have a white or gray color. Each of the embodiments will be described later.

The cover panel CVP according to an embodiment of the inventive concept may be in contact with the display panel EP. For example, the cover panel CVP may be in contact with a rear surface of the display panel EP.

The lower panel UP according to an embodiment of the inventive concept may include a first adhesive layer AP1, a second adhesive layer AP2, and a protective layer PF. The first adhesive layer AP1 may have adhesiveness, and may be disposed between the display panel EP and the protective layer PF, and bonded to each of the display panel EP and the protective layer PF. The protective layer PF may be disposed under the display panel EP. The second adhesive layer AP2 may be disposed under the protective layer PF.

However, an embodiment of the inventive concept is not limited to what is illustrated in the drawing, and the first adhesive layer AP1 and the second adhesive layer AP2 may be omitted, and thus the protective layer PF may be bonded to the display panel EP.

The lower member UM according to an embodiment of the inventive concept may include a cushion layer FF, a third adhesive layer AP3, a support layer UF, or the like. In the drawing, it is illustrated that the lower member UM includes the cushion layer FF, the support layer UF disposed under the cushion layer FF, and the third adhesive layer AP3 bonded to each of the cushion layer FF and the support layer UF, but an embodiment of the inventive concept is not limited thereto. The lower member UM may include other components, and the stacked structure of the components may be changed.

The cushion layer FF may be provided in order to protect the display panel EP and the electronic module EM from physical impact applied from the outside of the electronic device. The cushion layer FF may have rigidity enough to protect the display panel EP and the electronic module EM, and to have the opening UM-OP of the lower member UM defined therein. Moreover, the cushion layer FF may be made of a synthetic resin foam for absorbing the impact.

The support layer UF may be a supporting substrate which supports the members included in the electronic device ED which has the display panel EP. For example, the support layer UF may be made of metal, and may be a thin-film metal substrate. The support layer UF may have functions of heat dissipation, electromagnetic wave shield, etc.

The first adhesive layer AP1, the second adhesive layer AP2, and the protective layer PF may not overlap the opening UP-OP. The second adhesive layer AP2 may be disposed between the protective layer PF and the cushion layer FF and may be in contact with each of the protective layer PF and the cushion layer FF.

The cushion layer FF, the third adhesive layer AP3, and the support layer UF may not overlap the opening UM-OP.

The first adhesive layer AP1, the protective layer PF, the second adhesive layer AP2, the cushion layer FF, the third adhesive layer AP3, and the support layer UF may be placed farther away from the rear surface of the display panel EP in this order. The adhesive layers AP1, AP2, and AP3 according to an embodiment of the inventive concept may be optically clear adhesive layers. Alternatively, the adhesive layers AP1, AP2, and AP3 may be pressure sensitive adhesives.

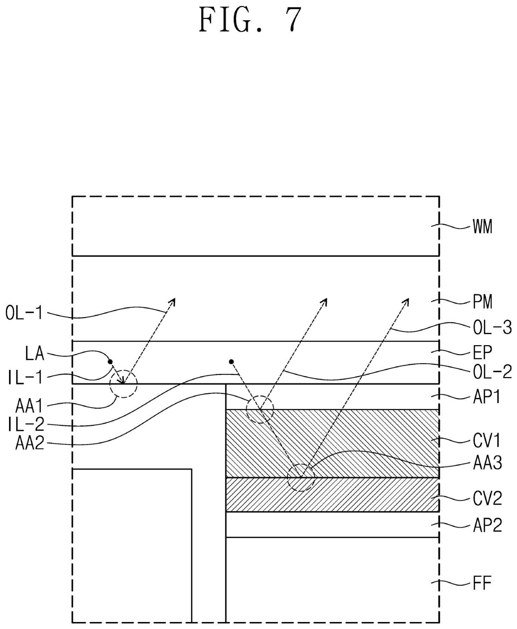

The protective layer PF may include a first cover layer CV1 (see FIG. 7) and a second cover layer CV2 (see FIG. 7) as illustrated in FIG. 7 to be described later.

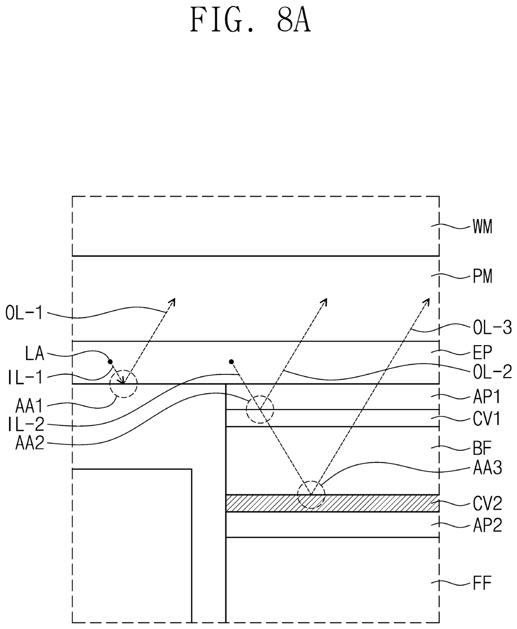

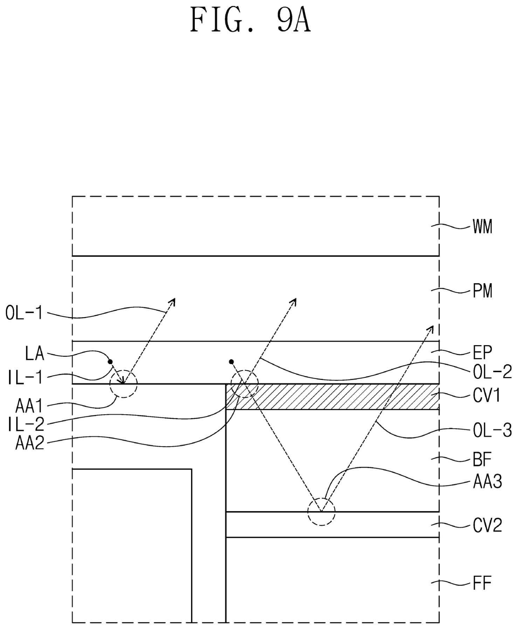

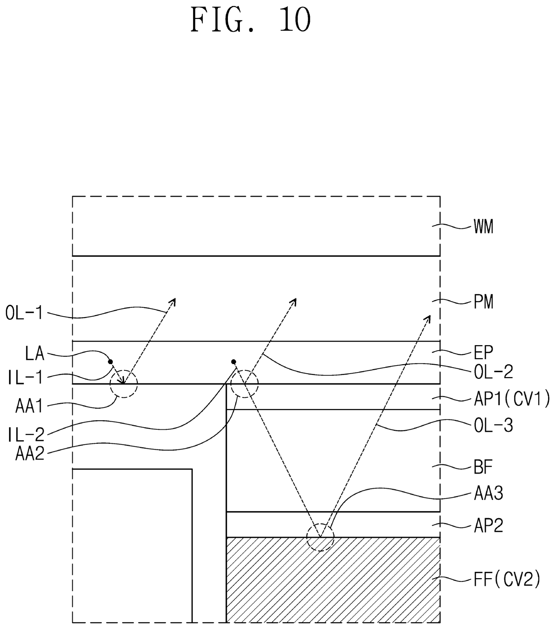

However, an embodiment of the inventive concept is not limited thereto, and the protective layer PF may include a first cover layer CV1 (see FIG. 8A), a second cover layer CV2 (see FIG. 8A), and a protective film BF (see FIG. 8A), as illustrated in FIG. 8A to be described later, or the protective layer PF may be a protective film BF (see FIGS. 9A and 10) as illustrated in FIGS. 9A, 10, and 11 to be described later.

The component/components constituting the protective layer PF is/are not limited to any one embodiment. Each of embodiments of the inventive concept will be described later.

According to an embodiment of the inventive concept, the protective layer PF may have a gray color reflectance. However, an embodiment of the inventive concept is not limited thereto, and the cover panel CVP as a whole may have a gray color reflectance, and the protective layer PF may have a white color reflectance, or only a portion of the protective layer PF may have a black color reflectance.

The second light LA-IL emitted from the light source LA toward the cover panel CVP may be reflected on a surface where each of layers constituting the cover panel CVP comes into contact. However, an embodiment of the inventive concept is not limited thereto, and the light may also be reflected inside each of the components.

In an embodiment of the inventive concept, the cover panel CVP having substantially the same color reflectance as the gray color means that the reflectance of light reflected inside or between each of the components included in the cover panel CVP and the second light LA-IL incident to the cover panel CVP be the same as the gray color reflectance.

The electronic module EM may overlap the opening of the cover panel CVP on a plane. In particular, the electronic module EM may overlap the opening UP-OP of the lower panel UP and the opening UM-OP of the lower member UM on a plane. In an embodiment, the electronic module EM may be accommodated in the opening of the cover panel CVP. A side surface EM-S of the electronic module EM may be spaced apart from the opening of the cover panel CVP.

As illustrated in the drawing, the protective layer PF may be a single layer. However, an embodiment of the inventive concept is not limited thereto, and the protective layer PF may include a plurality of layers.

According to an embodiment of the inventive concept, the protective layer PF may include a polyethylene terephthalate (PET) film.

According to an embodiment of the inventive concept, the cover panel CVP may include a light-blocking layer. The light-blocking layer may have light-shielding effect. The light-blocking layer may be a bonding member including a black dye or pigment. The light-blocking layer may be provided in the form of a bonding film made of a light-blocking resin including a base resin such as an acrylic resin, a silicon resin, a urethane resin, or an imide resin, and a dye or pigment, or the light-blocking layer may be provided as a bonding layer formed by photocuring or thermal-curing a liquid light-blocking resin. The light-blocking layer included in the protective layer PF may have a black color. However, an embodiment of the inventive concept is not limited thereto, and the light-blocking layer includes a light-blocking material, and the color is not limited to the black color.

FIG. 7 is a cross-sectional view illustrating a portion of an electronic device according to an embodiment of the inventive concept. In particular, FIG. 7 is an enlarged view of a dotted portion of FIG. 6. Components constituting a lower panel in FIG. 7 may be partially different from what is illustrated in FIG. 6.

For the convenience of description, FIG. 7 only illustrates that the first light IL-1 emitted from the light source LA of the display panel EP toward the opening UP-OP (see FIG. 6) is reflected as first reflected light OL-1 in a first region AA1 of the rear surface of the display panel EP. However, in consideration of a relationship between the first incident light IL-1 and the display panel EP, the region where the reflected light is formed is not limited to the first region AA1, and the reflected light may also be formed between the light source LA and the rear surface of the display panel EP.

It is only illustrated that second incident light IL-2, which is incident from the light source LA of the display panel EP toward the cover panel CVP (see FIG. 6), is reflected as second reflected light OL-2 in a second region AA2 between the first adhesive layer AP1 and a first cover layer CV1, and the second incident light IL-2 is reflected as third reflected light OL-3 in a third region AA3 between the first cover layer CV1 and a second cover layer CV2. However, in consideration of a relationship between the second incident light IL-2 and the cover panel CVP (see FIG. 6), the portion where the reflected light is formed is not limited thereto, and light may be reflected between the second cover layer CV2 and a second adhesive layer AP2, or the reflected light may be formed in each of the components or formed between the components.

As previously described with reference to FIG. 6, in FIG. 7, the protective layer PF of the cover panel CVP may include a first cover layer CV1 and a second cover layer CV2. The first cover layer CV1 may have a first reflectance, and the second cover layer CV2 may have a second reflectance.

The reflectance of the first cover layer CV1 may be substantially same as the reflectance of the second cover layer CV2. To be substantially the same means that the first and second cover layers CV1 and CV2 have the same color, and may thus have the same color reflectance. The first cover layer CV1 and the second cover layer CV2 may have a white color or a gray color, and the color reflectance of each of the first cover layer CV1 and the second cover layer CV2 may correspond to the white or gray color reflectance.

At this time, considering the reflectance of each of the first cover layer CV1 and the second cover layer CV2 together with the reflectance of each of the first adhesive layer AP1, the second adhesive layer AP2, and the cushion layer FF, the cover panel CVP (see FIG. 6) may have a gray color reflectance.

FIGS. 8A through 8D are cross-sectional views each illustrating a portion of an electronic device according to an embodiment of the inventive concept. In particular, FIGS. 8A through 8D illustrate different embodiments from the embodiment illustrated in FIG. 7.

Referring to FIG. 8A, as previously described with reference to FIG. 6, a protective layer PF of a cover panel CVP may have a first cover layer CV1, a second cover layer CV2, and a protective film BF. The protective film BF may be provided between the first cover layer CV1 and the second cover layer CV2.

According to an embodiment of the inventive concept, the first cover layer CV1 may be in contact with one side surface of the protective film BF, and the second cover layer CV2 may be in contact with the other side surface of the protective film BF. For example, the first cover layer CV1 and the second cover layer CV2 may be print layers or coating layers on the protective film BF. That is, the first cover layer CV1 may be a first print layer on one side surface of the protective film BF, and the second cover layer CV2 may be a second print layer on the other side surface of the protective film.

First incident light IL-1 may be reflected in a first region AA1 of a rear surface of a display panel to form first reflected light OL-1, second incident light IL-2 may be reflected in a second region AA2 between a first adhesive layer AP1 and the first cover layer CV1 to form second reflected light OL-2, and the second incident light IL-2 may be reflected in a third region AA3 between the protective film BF and the second cover layer CV2 to form third reflected light OL-3.

As described with reference to FIG. 7, for the convenience of description, only some reflected light is illustrated in the drawing, but in consideration of a relationship between the first incident light IL-1 and the display panel EP, the region where the reflected light is formed is not limited only to the first region AA1, and in consideration of a relationship between the second incident light IL-2 and the cover panel CVP (see FIG. 6), the region where the reflected light is formed is not limited to the second region AA2 or the third region AA3.

According to an embodiment of the inventive concept, the first reflectance of the first cover layer CV1 may be greater than the second reflectance of the second cover layer CV2. The first cover layer CV1 may have a white color, and the second cover layer CV2 may have a gray or black color. That is, the first cover layer CV1 may have a color reflectance corresponding to the white color, and the second cover layer CV2 may have a color reflectance corresponding to the gray or black color. Alternatively, the first cover layer CV1 may be a transparent layer.

The protective film BF may have a reflectance equal to or greater than the second reflectance of the second cover layer CV2. For example, the protective film BF may have a color reflectance corresponding to the white color, or may be a transparent layer.

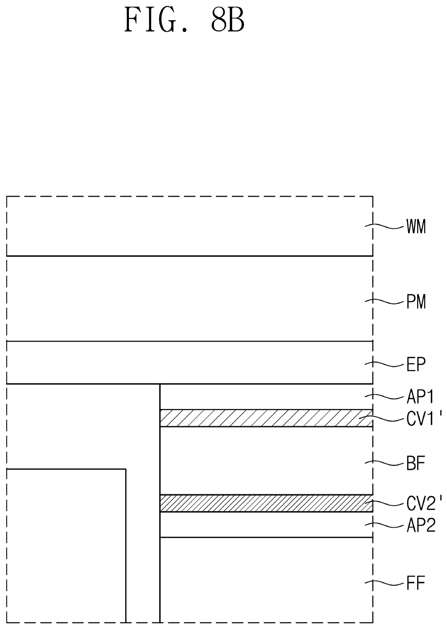

At this time, considering the reflectance of each of the first cover layer CV1, the protective film BF, and the second cover layer CV2 together with the reflectance of each of a first adhesive layer AP1, a second adhesive layer AP2, and a cushion layer FF, the cover panel CVP (see FIG. 6) may have a gray color reflectance. Hereinafter, in embodiments of FIGS. 8B through 8D, as in the embodiment of FIG. 8A, the cover panel CVP (see FIG. 6) may also have a gray color reflectance in consideration of the color reflectance of each of the components of the cover panel CVP (see FIG. 6).

According to an embodiment, the second cover layer CV2 may be provided to have the aforementioned function of a light-blocking layer.

Hereinafter, in FIGS. 8B through 8D, different configuration from what is illustrated in FIG. 8A will be described in detail.

Referring to FIG. 8B, a first cover layer CV1' may have a gray color, and a second cover layer CV2' may have a gray or black color. A first reflectance of the first cover layer CV1' may be equal to or greater than the color reflectance of the second cover layer CV2'.

That is, the first cover layer CV1' may have a color reflectance corresponding to the gray color, and the second cover layer CV2' may have a color reflectance corresponding to the gray or black color.

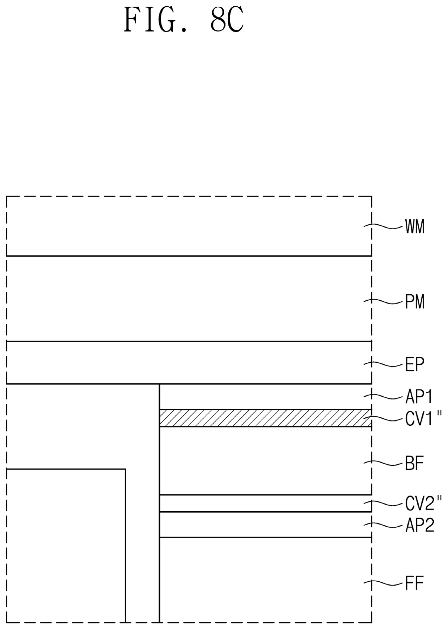

Referring to FIG. 8C, a first reflectance of a first cover layer CV1" may be greater than a second reflectance of a second cover layer CV2".

The first cover layer CV1" may have a gray color, and the second cover layer CV2" may have a white color. Alternatively, the second cover layer CV2" may also be a transparent layer.

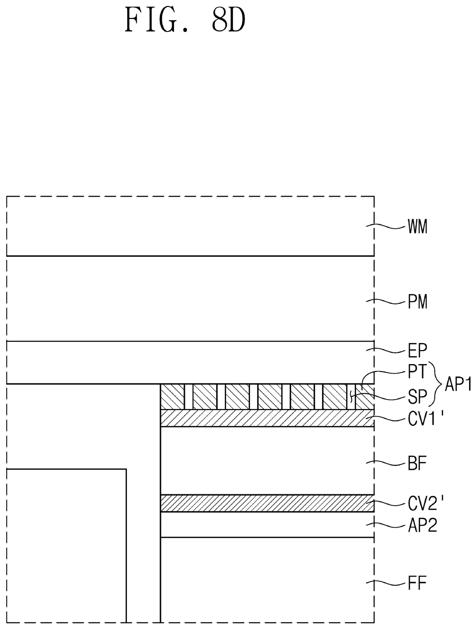

Referring to FIG. 8D, a first adhesive layer AP1 according to an embodiment of the inventive concept may include a plurality of patterns PT in which a resin is applied in patterns, and a resin-unapplied space SP between the plurality of patterns PT. The first cover layer CV1' may have a reflectance greater than the second cover layer CV2'.

The plurality of patterns PT may include an embossed pattern having fine convex portions and concave portions. After the embossed pattern is formed to have double-sided adhesiveness, a target object may be bonded to both sides, and may then be pressurized so that the convex portions are compressed to be flattened on a plane, and in the process of the concave portions narrowing, degassing may take place through the concave portions. After such pressurization is finished, a flat adhesive layer without gas or an embossed pattern may be formed. That is, unlike typical adhesive layers, the adhesive layer according to the inventive concept may prevent air bubbles from being trapped, thereby preventing deterioration of adhesiveness.

According to an embodiment of the inventive concept, the target object may be the display panel EP or the cover panel CVP (see FIG. 6). In particular, the first adhesive layer AP1 may be bonded to each of the display panel EP and the first cover layer CV1'.

FIGS. 9A through 9C are cross-sectional views each illustrating a portion of an electronic device according to an embodiment of the inventive concept. In particular, FIGS. 9A through 9C illustrate different embodiments from the embodiments of FIGS. 7, and 8A through 8D.

Referring to FIG. 9A, as previously described with reference to FIG. 6, a protective layer PF of a cover panel CVP may be a protective film BF.

First incident light IL-1 may be reflected in a first region AA1 of a rear surface of a display panel EP to form first reflected light OL-1, second incident light IL-2 may be reflected in a second region AA2 between the rear surface of the display panel EP and a first cover layer CV1 to form second reflected light OL-2, and the second incident light IL-2 may be reflected in a third region AA3 between the protective film BF and a second cover layer CV2 to form third reflected light OL-3.

For the convenience of description, only some reflected light is illustrated in the drawing, but in consideration of a relationship between the first incident light IL-1 and the display panel EP, the region where the reflected light is formed is not limited to the first region AA1, and in consideration of a relationship between the second incident light IL-2 and the cover panel CVP (see FIG. 6), the region where the reflected light is formed is not limited to the second region AA2 or the third region AA3.

For example, the first cover layer CV1 may have adhesiveness and may be in contact with each of the display panel EP and the protective film BF. In addition, the second cover layer CV2 may have adhesiveness and may be in contact with each of the protective film BF and a cushion layer FF.

The first cover layer CV1 and the second cover layer CV2 may be optically transparent adhesive layers, but an embodiment of the inventive concept is not limited thereto, and the first and second cover layers CV1 and CV2 may be pressure-sensitive adhesives. For example, the first cover layer CV1 may be an embossed pressure-sensitive adhesive.

The first cover layer CV1 may have a smaller reflectance than the second cover layer CV2. The first cover layer CV1 may have a gray or white color reflectance. The second cover layer CV2 may have a white color reflectance, or may be a transparent layer.

At this time, considering the reflectance of each of the first cover layer CV1 and the second cover layer CV2 together with the reflectance of each of the protective film BF and the cushion layer FF, the cover panel CVP (see FIG. 6) may have a gray color reflectance.

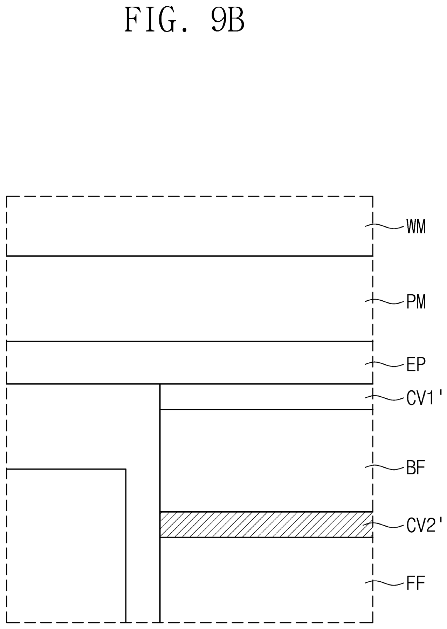

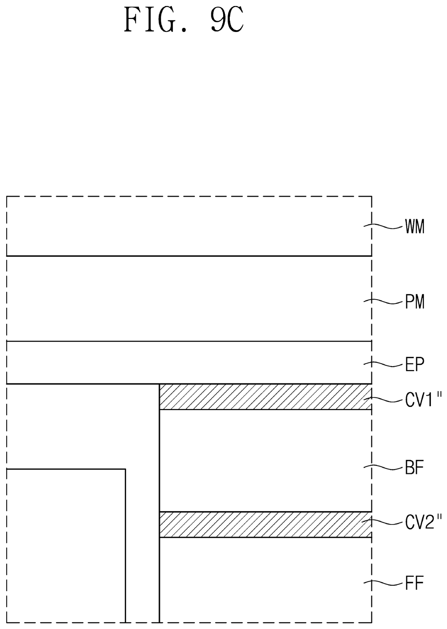

Hereinafter, in embodiments of FIGS. 9B and 9C, as in FIG. 9A, the cover panel CVP (see FIG. 6) may have a gray color reflectance in consideration of the color reflectance of each of the components included in the cover panel CVP (see FIG. 6).

Hereinafter, in FIGS 9B and 9C, a configuration different from what is illustrated in FIG. 9A will be described in detail.

Referring to FIG. 9B, a first cover layer CV1' may have a larger reflectance than a second cover layer CV2'. The first cover layer CV1' may have a white color reflectance, or may be a transparent layer. The second cover layer CV2' may have a gray color reflectance or black color reflectance.

Referring to FIG. 9C, a first reflectance of a first cover layer CV1" may be substantially same in color reflectance as a second reflectance of a second cover layer CV2". The first cover layer CV1" and the second cover layer CV2" may each have a gray color reflectance.

FIG. 10 is a cross-sectional view of an electronic device according to an embodiment of the inventive concept. In particular, FIG. 10 illustrates a different embodiment from the embodiments of FIGS. 7, 8A through 8D, and 9A through 9C.

Referring to FIG. 10, as previously described with reference to FIG. 6, a protective layer PF of a cover panel CVP may be a protective film BF.

First incident light IL-1 may be reflected in a first region AA1 of a rear surface of a display panel EP to form first reflected light OL-1, second incident light IL-2 may be reflected in a second region AA2 between the rear surface of the display panel EP and a first cover layer CV1 to form second reflected light OL-2, and the second incident light IL-2 may be reflected in a third region AA3 between a second adhesive layer AP2 and a second cover layer CV2 to form third reflected light OL-3. At this time, the first cover layer CV1 may be a first adhesive layer, and the second cover layer CV2 may be a cushion layer FF.

For the convenience of description, only some reflected light is illustrated in the drawing, but in consideration of a relationship between the first incident light IL-1 and the display panel EP, the region where the reflected light is formed is not limited to the first region AA1, and in consideration of a relationship between the second incident light IL-2 and the cover panel CVP (see FIG. 6), the region where the reflected light is formed is not limited to the second region AA2 or the third region AA3.

A first reflectance of the first cover layer CV1 may be smaller than a second reflectance of the second cover layer CV2. At this time, the first cover layer CV1 may be the first adhesive layer AP1 previously described with reference to FIG. 6, and the second cover layer CV2 may be the cushion layer FF previously described with reference to FIG. 6.

Each of the first cover layer CV1, the protective film BF, or the second adhesive layer AP2 may have a white color reflectance, or may be a transparent layer. The second cover layer CV2 may have a gray or black color. However, even in this case, the color reflectance of the cover panel CVP is substantially same as the gray color reflectance.

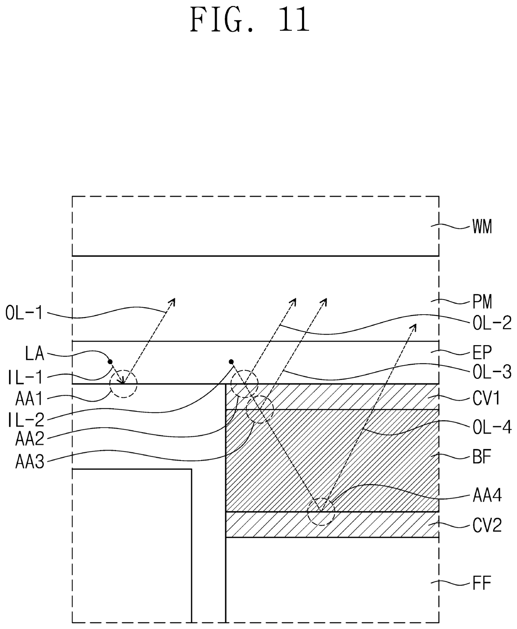

FIG. 11 is a cross-sectional view illustrating a portion of an electronic device according to an embodiment of the inventive concept. In particular, FIG. 11 illustrates a different embodiment from the embodiments of FIGS. 7, 8A through 8D, 9A through 9C, and 10.

Referring to FIG. 11, first incident light IL-1 may be reflected in a first region AA1 of a rear surface of a display panel EP to form first reflected light OL-1, second incident light IL-2 may be reflected in a second region AA2 between the rear surface of the display panel EP and a first cover layer CV1 to form second reflected light OL-2, the second incident light IL-2 may be reflected in a third region AA3 between the first cover layer CV1 and a protective film BF to form third reflected light OL-3, and the second incident light IL-2 may be reflected in a fourth region AA4 between the protective film BF and a second cover layer CV2 to form fourth reflected light OL-4.

For the convenience of description, only some reflected light is illustrated in the drawing, but in consideration of a relationship between the first incident light IL-1 and the display panel EP, the region where the reflected light is formed is not limited to the first region AA1, and in consideration of a relationship between the second incident light IL-2 and the cover panel CVP (see FIG. 6), the region where the reflected light is formed is not limited to the second region AA2, the third region AA3, or the fourth region AA3.

Referring to FIG. 11, as previously described with reference to FIG. 6, a protective layer PF of the cover panel CVP may be a protective film BF.

The first cover layer CV1 may have a first reflectance, and the second cover layer CV2 may have a second reflectance. The first cover layer CV1 may have adhesiveness and may be in contact with each of the display panel EP and the protective film BF. In addition, the second cover layer CV2 may have adhesiveness and may be in contact with each of the protective film BF and a cushion layer FF.

The reflectance of the first cover layer CV1 may be substantially same as the reflectance of the second cover layer CV2. To be substantially the same means to have the same color and have the same color reflectance. The first cover layer CV1 and the second cover layer CV2 may each have a white or gray color, and the color reflectance of each of the first cover layer CV1 and the second cover layer CV2 may correspond to the white or gray color reflectance.

The protective film BF may have a color reflectance corresponding to the gray color reflectance.

At this time, considering the reflectance of each of the first cover layer CV1 and the second cover layer CV2 together with the reflectance of each of the first adhesive layer AP1, the second adhesive layer AP2, and the cushion layer FF, the cover panel CVP (see FIG. 6) may have a gray color reflectance.

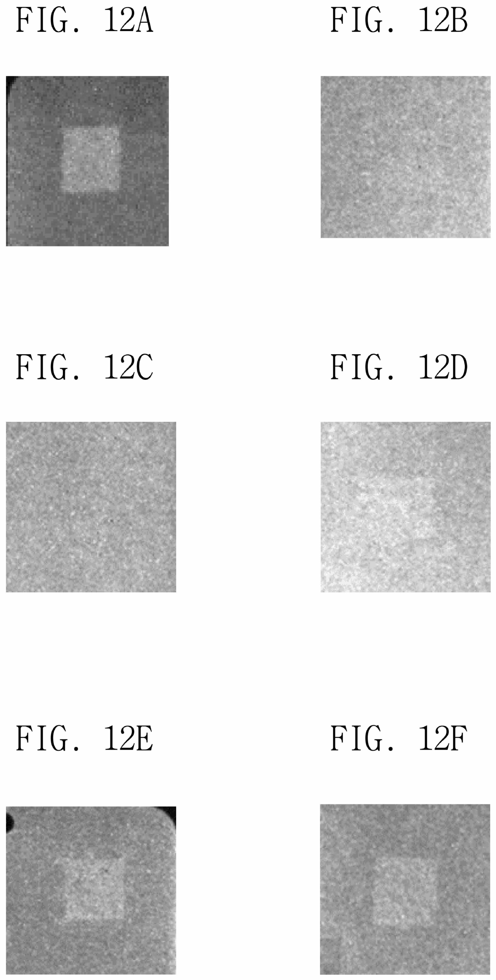

FIGS. 12A through 12F are photos each showing the luminance difference in a display region.

Referring to FIGS. 12A through 12F, FIG. 12A shows the luminance difference in the display region corresponding to CASE 1 to be described, FIG. 12B shows the luminance difference corresponding to CASE 2 to be described, FIG. 12C shows the luminance difference corresponding to CASE 3 to be described, FIG. 12D shows the luminance difference corresponding to CASE 4 to be described, FIG. 12E shows the luminance difference corresponding to CASE 5 to be described, and FIG. 12F shows the luminance difference corresponding to CASE 6.

Table 1 below shows the respective luminance differences, and the respective reflectances of the cover panels, corresponding to CASEs 1 through 6 in FIGS. 12A through 12F. The reflectance of the cover panel and luminance difference of each CASE as measured below correspond to those measured when the brightness of light emitted from a light source of a display panel is about 0.02 nit.

The luminance difference described below represents the difference in luminance between a portion where a cover panel of an electronic device overlaps an opening and a portion where the cover panel does not overlap the opening.

CASE 1 is a case where a protective layer includes a transparent protective film, and a light-blocking layer having a black color and disposed under the protective film.

CASE 2 is a case where a protective layer includes a transparent protective film, and a first cover layer and a second cover layer each having a predetermined color reflectance. In addition, an embossed pressure sensitive adhesive (PSA) is used for a first adhesive layer positioned above the protective layer. In particular, the first cover layer is printed in white color three times, and the second cover layer is printed in black color two times.

CASE 3 is a case where a protective layer includes a transparent protective film, a first cover layer and a second cover layer each having a predetermined color reflectance. Compared to CASE 2, CASE 3 is a case where a general pressure sensitive adhesive (PSA) is used for a first adhesive layer positioned above the protective layer, and the first cover layer is printed in white color, and the second cover layer is printed in black color.

Compared to CASE 3, CASE 4 is a case where the color change rates of the cover layers are partially changed, the first cover layer is printed in gray color, and the second cover layer is printed in black color.

CASE 5 is a case where a protective layer is composed of an adhesive layer having a gray color.

Compared to CASE 2, CASE 6 is a case where the first cover layer is printed in white color once, and the second cover layer is printed in black color two times.

**[Table 1]**

| | CASE 1 | CASE 2 | CASE 3 | CASE 4 | CASE 5 | CASE 6 |
|---|---|---|---|---|---|---|
| Reflectance of cover panel | 3.6 % | 49.3% | 66.3% | 35.7% | 23.5% | 25.6% |
| Luminance difference | 15.3% | 1.5% | 3.2% | 9.8% | 8.9% | 9.7% |

As the luminance difference is smaller, the difference in amount of light reflected between a portion of the cover panel overlapping an opening and a portion of the cover panel not overlapping the opening is reduced. As the difference in amount of light is reduced, light stains may be prevented from being generated in the display region of the electronic device, thereby securing the uniformity of exterior display quality of the electronic device. Each of CASEs 2 through 6 where the reflectance of the cover panel is about 23.5 % to about 66.3% has a smaller luminance difference than CASE 1 where the reflectance of the cover panel is about 3.6%.

Each of CASE 2 and CASE 3 where the reflectance of the cove panel is at least about 49.3% has a smaller luminance difference than each of CASEs 4 through 6 where the reflectance of the cover panel is about 23.5% to about 35.7%.

In CASE 5, a protective layer is composed of an adhesive layer having a gray color.

In each of CASE 4 and CASE 6, a protective layer includes a transparent protective film, and a first cover layer and a second cover layer each having a predetermined color reflectance. In each of CASE 2 and CASE 3, as CASE 4 and CASE 6, a transparent protective film, and a first cover layer or a second cover layer each having a predetermined color reflectance may be included. At this time, the protective film may have a higher rigidity than an adhesive layer.

Accordingly, since the protective layer in each of CASE 4 and CASE 6 has more protective films, the protective layer in each of CASE 4 and CASE 6 may have a higher rigidity than in CASE 5, thereby improving support of the cover panel for the display panel. The protective layer in each of CASE 2 and CASE 3 may have more protective films and thus have a higher rigidity than in CASE 5, and the reflectance of the cover panel may be about 49.3% or more, thereby achieving a smaller difference in luminance than in CASE 4.

Although the embodiments of the inventive concept have been described, it is understood that the inventive concept should not be limited to these embodiments but various changes and modifications can be made by one ordinary skilled in the art within the spirit and scope of the inventive concept as hereinafter claimed. Therefore, the technical scope of the inventive concept should not be limited to the contents described in the detailed description of the specification, but should be defined by the claims.

### INDUSTRIAL APPLICABILITY

The electronic device may improve display characteristics and reduce brightness deviation between an opening of a cover panel and an area adjacent thereto. Therefore, the present invention has industrial applicability.

## Claims

1. An electronic device comprising:
a display panel configured to display an image;
a cover panel contacting a lower part of the display panel, having an opening defined therein, and having a gray color reflectance; and
an electronic module disposed overlapping the opening on a plane,
wherein the cover panel includes
a first cover layer not overlapping the opening, and having a first reflectance,
a second cover layer not overlapping the opening, disposed under the first cover layer, and having a second reflectance.

2. The electronic device of claim 1, wherein the second reflectance is equal to or less than the first reflectance.

3. The electronic device of claim 1, wherein the cover panel has a reflectance equal to or greater than that of the display panel.

4. The electronic device of claim 1, wherein one of the first cover layer and the second cover layer has a gray color, and the other of the first cover layer and the second cover layer has a white color.

5. The electronic device of claim 1, wherein the first cover layer has a gray color or a white color, and
the second cover layer has a gray color or a black color.

6. The electronic device of claim 1, wherein the cover panel further comprises a protective film disposed between the first cover layer and the second cover layer.

7. The electronic device of claim 6, wherein the protective film is a transparent layer.

8. The electronic device of claim 6, wherein the protective film has a reflectance equal to or greater than the second reflectance.

9. The electronic device of claim 6, wherein the cover panel comprises a lower member disposed under the second cover layer,
the first cover layer has adhesiveness, and is in contact with each of the protective film and the display panel, and
the second cover layer has adhesiveness, and is in contact with each of the protective film and the lower member.

10. The electronic device of claim 6, wherein the first cover layer has adhesiveness, and is in contact with each of the protective film and the display panel, and
the second cover layer is a cushion layer.

11. The electronic device of claim 6, wherein the first cover layer is in contact with one side of the protective film, and
the second cover layer is in contact with the other side of the protective film.

12. The electronic device of claim 6, wherein the first cover layer comprises a plurality of patterns, and bonds the protective film and the display panel to each other.

13. An electronic device comprising:
a display panel configured to display an image;
a cover panel contacting a lower part of the display panel, and having an opening defined therein; and
an electronic module disposed overlapping the opening on a plane,
wherein the cover panel includes
a protective film not overlapping the opening,
a first cover layer disposed between the display panel and the protective film, and in contact with the protective film, and
a second cover layer disposed under the protective film, and in contact with the protective film, and
the cover panel has a reflectance which is a color reflectance of about 15% to about 70%.

14. The electronic device of claim 13, wherein the first cover layer has a gray color or a white color, and
the second cover layer has a gray color or a black color.

15. The electronic device of claim 13, wherein the cover panel comprises:
a lower member disposed under the second cover layer;
a first adhesive layer which has adhesiveness, and is in contact with each of the display panel and the first cover layer; and
a second adhesive layer which has adhesiveness, and is in contact with each of the second cover layer and the lower member.

16. The electronic device of claim 15, wherein one among the first adhesive layer, the first cover layer, the protective film, the second cover layer, and the second adhesive layer has a white color or a gray color, and
the others among the first adhesive layer, the first cover layer, the protective film, the second cover layer, and the second adhesive layer are transparent layers.

17. The electronic device of claim 15, wherein the first adhesive layer has a white color or a gray color, and
the second adhesive layer has a white color or a gray color.

18. The electronic device of claim 15, wherein the protective film, the first cover layer, the second cover layer, the first adhesive layer, and the second adhesive layer are transparent, and
the lower member has a reflectance substantially equal to a gray color reflectance.

19. An electronic device comprising:
a display panel configured to display an image;
a cover panel contacting a lower part of the display panel, having an opening defined therein, and having a gray color reflectance; and
an electronic module disposed overlapping the opening on a plane,
wherein the cover panel includes
a protective film not overlapping the opening,
a first cover layer disposed between the display panel and the protective film, and in contact with the protective film,
a first adhesive layer disposed between the first cover layer and the display panel, and in contact with each of the first cover layer and the display panel,
a lower member disposed under the protective film,
a second cover layer disposed between the lower member and the protective film, and in contact with the protective film, and
a second adhesive layer disposed between the second cover layer and the lower member, and in contact with each of the second cover layer and the lower member.

20. The electronic device of claim 19, wherein the protective film is a transparent layer,
the first cover layer has a gray color or a white color, and
the second cover layer has a gray color or a black color.
